# EUROPEAN PATENT APPLICATION

(11) **EP 2 787 669 A2**
(43) Date of publication of application: **08.10.2014**
(21) Application number: 14163530.0
(22) Date of filing: 04.04.2014
(51) Int. Cl.: H04K 3/00

(54) **Methods of and apparatus for logging and/or comparing radio frequency spectrum data**

(30) Priority: 05.04.2013 GB 201306204; 19.09.2013 GB 201316615
(71) Applicant: Winkelmann (UK) Limited, Near Crawley, West Sussex Sussex RH10 4NQ (GB)
(72) Inventor: Edmans, Michael Andrew, West Sussex, Sussex RH10 4NQ (GB)
(74) Representative: Tothill, John Paul

(57) **Abstract**

Radio signals over a spectrum of radio frequencies are sampled (404) for individual time periods of a set of plural time periods to give respective spectrum data for each of the time periods (of the set of plural time periods). The respective spectrum data for each of the time periods (of the set of plural time periods) is then stored in memory (406). The respective spectrum data for subsets of time periods (of the set of plural time periods) is then consolidated (408) to give respective consolidated spectrum data for each of the subsets of time periods (of the set of plural time periods). The respective consolidated spectrum data for each of the subsets of time periods (of the set of plural time periods) is then stored in memory (414). The step of consolidating respective spectrum data for subsets of time periods is repeated (416, 424) for progressively larger subsets of time periods.

## Description

The present invention relates to methods of and apparatus for logging and/or comparing radio frequency spectrum data, particularly for the purpose of detecting covert radio transmitters or "bugs".

As is known in the art, spectrum analysers are pieces of electronic apparatus which analyse radio signals. Spectrum analysers may display radio frequency spectrum data as a graph of signal strength against signal frequency. This can be used to display the radio signals transmitted in an area. By examining each radio signal, a user of the spectrum analyser can identify which signals are harmless or which signals are potentially from hidden transmitters.

Many modern bugging devices do not transmit continuously. They may be remote-controlled, and transmit only when some activity of interest (such as an important meeting) is occurring. Alternatively they may record audio or video to memory and transmit that information digitally at a later time (this is called a store-forward transmitter). This may make it easier for the team carrying out the surveillance as they do not have to be close to the premises all the time, but can pass by a few times a week and download recorded data from the store-forward transmitter. This makes it difficult for teams searching for bugging devices as the devices will probably not be transmitting at the time they are performing a sweep for bugging devices.

A commonly-used method of detecting remote control or store-forward devices is to leave a spectrum analyser running continuously, storing the spectrum data to a hard disk or memory. When the operator returns, they can look at the radio spectrum at any moment in time when the spectrum analyser was running and storing information to disk. This information is commonly displayed as a "waterfall display", i.e. in which frequency is shown along one axis and time along a second axis, and signal strength (amplitude) is represented visually using, e.g. colours and/or shading, and/or along a third axis.

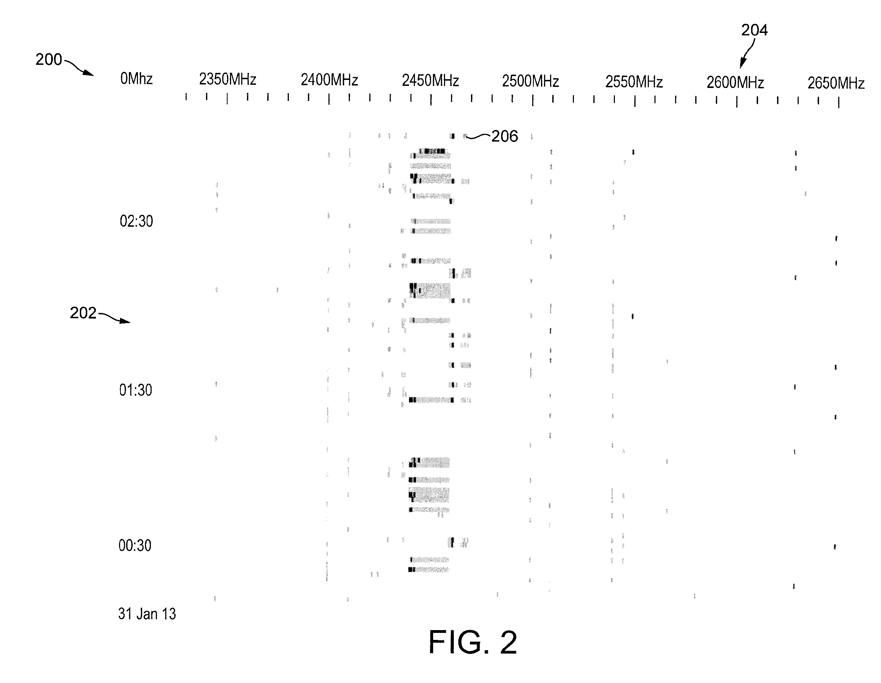

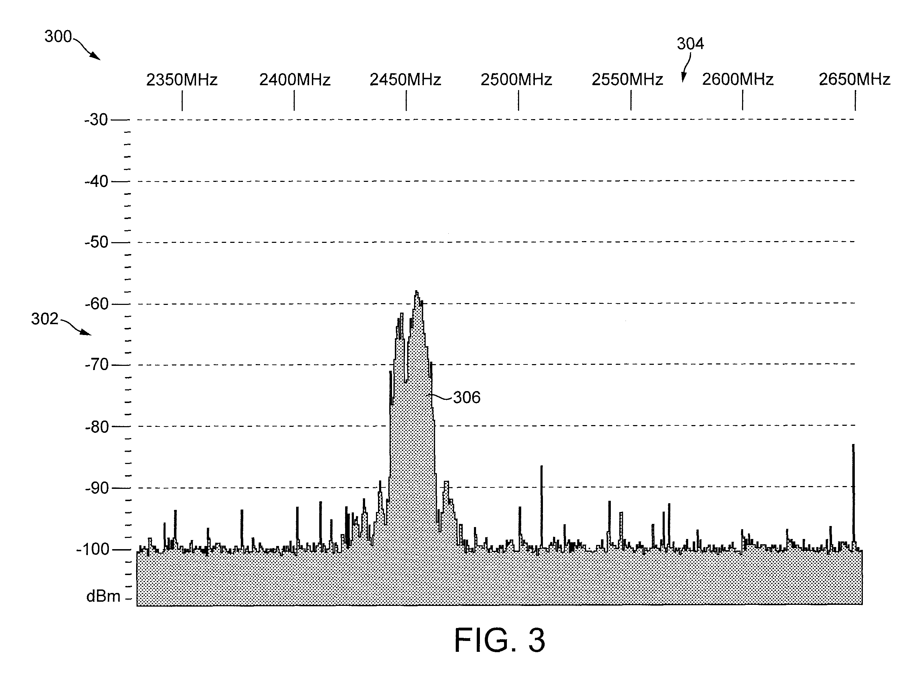

An example of a waterfall display is shown in Figure 2. The display allows the user to look for strong signals across frequency and time. The user may then see a moment in time at which there is a signal of interest and click on that moment in time in the time axis to display the spectrum as a more conventional spectrum analyser display, which gives more detail of the frequency signature of the spectrum at that moment. An example of a frequency signature is shown in Figure 3. However, if a spectrum analyser takes a sample every second, it can be laborious and burdensome to search the large amount of data which would be collected over a month looking for a radio signal whose duration might only be a few seconds.

It is also known to compare radio spectrum data from one moment in time and/or physical location with "reference" radio spectrum data from another moment in time and/or physical location, e.g. using a mathematical function. For example, the radio spectrum data in an area thought not to have any hostile transmissions (i.e., in a "safe area") could be recorded and saved, and this radio spectrum data recorded in the "safe area" then subtracted from radio spectrum data recorded in a target area of interest, and the difference between the two spectra displayed to a user. However, although this can allow signals of interest in target areas to be identified more easily, the user can still be required, as above, to search a large amount of data and this can be laborious and burdensome.

The Applicants therefore believe that there remains scope for improved techniques for logging and/or comparing radio frequency spectrum data.

According to an aspect of the present invention there is provided a method of logging radio frequency spectrum data comprising:
sampling radio signals over a spectrum of radio frequencies for each time period of a set of plural time periods to give respective spectrum data for each of the time periods of the set of plural time periods;
storing the respective spectrum data for each of the time periods of the set of plural time periods in memory;
consolidating the spectrum data for subsets of time periods of the set of plural time periods to give respective consolidated spectrum data for each of the subsets of time periods of the set of plural time periods; and
storing the consolidated spectrum data for each of the subsets of time periods in the set of plural time periods in memory.

According to another aspect of the present invention there is provided an apparatus comprising:
means (e.g. a receiver) for sampling radio signals over a spectrum of radio frequencies for each time period of a set of plural time periods to give respective spectrum data for each of the time periods of the set of plural time periods;
means (e.g. a memory) for storing the respective spectrum data for each of the time periods of the set of plural time periods in memory;
means (e.g. processing circuitry) for consolidating the spectrum data for subsets of time periods of the set of plural time periods to give respective consolidated spectrum data for each of the subsets of time periods of the set of plural time periods; and
means (e.g. a or the memory) for storing the consolidated spectrum data for each of the subsets of time periods in the set of plural time periods in memory.

In the present invention, spectrum data for each time period of a set of plural time periods (e.g. for each 1 second time period of a set of many 1 second time periods) and consolidated spectrum data for subsets of the time periods (e.g. for subsets comprising 10, 100, 1000, etc., successive 1 second time periods) are stored in memory. This means that both lower resolution (in time) spectrum data (i.e. the consolidated spectrum data) and higher resolution (in time) spectrum data (i.e. the "unconsolidated" spectrum data) for the set of plural time periods are present in memory. The lower resolution (consolidated) spectrum data can accordingly be more roughly but quickly analysed to select a subset of time periods of particular interest, and the higher resolution (unconsolidated) spectrum data for the time periods of the selected subset can then be analysed in greater detail. The present invention therefore provides a way to log spectrum data which can reduce the burden of analyzing large amounts of spectrum data whilst also allowing the finer detail of the spectrum data to be analysed.

In preferred embodiments the steps of sampling radio signals, storing the respective spectrum data and consolidating the spectrum data for a given subset of the time periods are performed concurrently.

Thus, embodiments of the present invention comprise sampling radio signals for a first time period of a first subset of the time periods, storing the spectrum data for the first time period and consolidating the spectrum data for the first subset of the time periods, and then subsequently sampling radio signals for a second time period of the first subset of the time periods, storing the spectrum data for the second time period and consolidating the spectrum data for the first subset of the time periods (and so on).

Similarly, embodiments of the present invention comprise sampling radio signals, storing the spectrum data and consolidating the spectrum data for a first subset of the time periods, and then subsequently sampling radio signals, storing the spectrum data and consolidating the spectrum data for a second subset of the time periods (and so on).

The above embodiments mean that the consolidation of the spectrum data is performed as the spectrum data for a subset of time periods is collected. This can reduce the processing time needed (e.g. to produce plots) once all the spectrum data for a subset of time periods or subsets of time periods is collected.

In preferred embodiments, the spectrum of radio frequencies is in the range 3 kHz to 300 GHz, more preferably in the range 3 kHz to 60 GHz, and even more preferably in the range 3 kHz to 30 GHz.

In preferred embodiments, the time period is in the range 50 milliseconds-300 seconds or 0.1-300 seconds, more preferably in the range 50 milliseconds-60 seconds or 0.1-60 seconds, and even more preferably in the range 50 milliseconds-2 seconds or 0.1-2 seconds, e.g. is 1 second.

The set of time periods can comprise any suitable and desired number of (successive) time periods. The set of time periods may comprise, for example, a set of time periods which make up a day, a week or a month. For example, where the time period is 1 second, the set of time periods may comprise at least 86,400 time periods (1 day's worth of time periods), at least 604,800 time periods (1 week's worth of time periods), or at least 2,419,200 time periods (1 month's worth of time periods).

The subsets of time periods can comprise any suitable and desired number of (successive) time periods of the set of time periods. However, in preferred embodiments, each subset comprises n^{m} time periods where n is an integer in the range 2-20 and/or where m is one or more integers selected from the group consisting of: 1, 2, 3, 4, and 5. For example, where n is 10, each subset may comprise 10, 100, 1000, 10,000 and/or 100,000 time periods. Preferably consolidation of spectrum data is generated for plural different sized subsets of time periods, e.g. for every 10 time periods, for every 100 time periods, for every 1000 time periods (and so on if desired).

In preferred embodiments, consolidated spectrum data for a larger subset of time periods (e.g. a subset comprising n^{m} time periods (e.g. 100 time periods, where n=10 and m=2)) may be derived from consolidated spectrum data for plural smaller subsets (e.g. from the consolidated spectrum data for n^{m-1} subsets (e.g. 10 subsets, where n=10 and m=2) comprising n^{m-1} time periods (e.g. 10 time periods, where n=10 and m=2)).

In preferred embodiments, sampling the radio signals over a spectrum of radio frequencies comprises sampling radio signal strength over the spectrum of radio frequencies. The strength of the radio signals over the spectrum of radio frequencies may be the power and/or amplitude of the radio signals over the spectrum of radio frequencies.

In preferred embodiments, consolidating the spectrum data for subsets of time periods of the set of plural time periods comprises retaining the peak signal strength at each sampled frequency during the subset of time periods in question. In other embodiments, consolidating the spectrum data for subsets of time periods of the set of plural time periods comprises integrating (e.g. summing) the signal strength for each sampled frequency during the subset of time periods in question.

In preferred embodiments, each time period is associated with a time stamp, the time stamp being stored in memory in association with the spectrum data for the time period.

In preferred embodiments, each subset of time periods is associated with a time stamp, the time stamp being stored in memory in association with the consolidated spectrum data for the subset. The time stamp may be the time stamp of one of the times periods in the subset of time periods (e.g. the time stamp of the first or last time period in the subset of time periods).

In preferred embodiments, the spectrum data and/or consolidated spectrum data is displayed (e.g. on a display screen) as a "waterfall" display, by plotting time (from an associated time stamp for the spectrum data) versus signal frequency, with signal strength (amplitude) for a given time and frequency preferably being indicated visually, e.g. using colour, brightness (e.g. brighter or darker colour), etc.. The waterfall display, could, e.g., be a two-dimensional display, with frequency on a first axis (e.g. the x-axis), and time on a second axis (e.g. the y-axis), or a three-dimensional display, with frequency on a first axis (e.g. the x-axis), time on a second axis (e.g. the y-axis), and signal strength (amplitude) on a third axis (e.g. the z-axis) (and also, e.g., being indicated visually, e.g. using colour, brightness (e.g. brighter or darker colour), etc.).

In preferred embodiments, the time resolution of the displayed data is changed by a user. When the user selects a first lower time resolution, preferably (only) the consolidated spectrum data for the (desired/selected) subset(s) of time periods is plotted and displayed. When the user selects a second higher time resolution, preferably (only) the respective spectrum data for the (desired/selected) time period(s) is plotted and displayed.

In preferred embodiments, a user can bookmark a point corresponding to a given frequency and time of interest. The bookmark may be indicated visually on the display (e.g. with an icon) regardless of resolution selected for display. This can allow the user to more easily locate the frequency and time of interest.

In preferred embodiments, the spectrum data for a (user selectable) time period and/or consolidated spectrum data for a (user selectable) subset of time periods can be displayed (e.g. on a display screen) by plotting signal strength versus signal frequency (by plotting a frequency signature).

In preferred embodiments, a user can implement a mathematical function, such as, and preferably, a subtraction function, via the "waterfall" display, e.g., and preferably, to allow spectrum data, e.g. for a given frequency and time of interest, to be compared with other spectrum data, e.g. for another time of interest, such as a reference spectrum (waveform).

In preferred such embodiments, the user can select spectrum data for a single point in time for use and storage as a reference waveform, e.g., and preferably, for use in a mathematical function(s). In a further embodiment, the spectrum data for a (user selectable) time range can be consolidated and stored as a reference waveform. Thus, a user can preferably select a time range in the display over which the spectrum data is then consolidated to provide a reference waveform.

In these embodiments, consolidating the spectrum data can again comprise, e.g., retaining the peak signal strength at each sampled frequency during the time period in question, or integrating (e.g. summing) the signal strength for each sampled frequency during the time period in question.

In another embodiment, the user may (manually) store a spectrum waveform (i.e. not from the waterfall display) and then select that stored waveform for use as a reference waveform, e.g. with the waterfall display.

In preferred embodiments, the (selected) reference waveform can be subtracted from the spectrum data displayed in a "waterfall display" (i.e. that plots frequency against time, e.g. having frequency along one axis (e.g. the x-axis) and time along another axis (e.g. the y-axis) (or vice-versa)), and the resulting signals displayed to the user. This allows measured time/frequency data to be compared with the reference waveform on a "waterfall display", thereby, e.g., allowing the user more easily to identify signals of interest. The waterfall display may, e.g., be two-dimensional or three dimensional, as discussed above.

In preferred embodiments, the user can select a plurality of reference waveforms, that are preferably then combined using a mathematical function such as a maximum function or a minimum function, to show, e.g., the maximum (or minimum) signal strength of the reference waveforms at each recorded frequency.

It is believed that facilitating such operations via a waterfall display may be new and advantageous in its own right, irrespective of how the radio frequency spectrum data is logged.

Thus, according to another aspect of the present invention, there is provided a method of analysing radio frequency spectrum data, the method comprising:
displaying a set of logged radio frequency spectrum data as a waterfall display;
selecting a reference waveform for use with the set of logged radio frequency spectrum data displayed on the waterfall display;
performing a mathematical function using the selected reference waveform; and
displaying the result of the mathematical function.

According to another aspect of the present invention, there is provided an apparatus for analysing radio frequency spectrum data, the apparatus comprising:
means (e.g. a display) for displaying a set of logged radio frequency spectrum data as a waterfall display;
means (e.g. a user interface) for selecting a reference waveform for use with the set of logged radio frequency spectrum data displayed on the waterfall display;
means (e.g. processing circuitry) for performing a mathematical function using the selected reference waveform; and
means (e.g. a or the display) for displaying the result of the mathematical function.

As will be appreciated by those skilled in the art, these aspects of the present invention can, and preferably do, include any one or more or all of the preferred and optional features of the invention, as appropriate.

Thus, for example, the set of radio frequency spectrum data that is displayed is preferably logged in the manner of the aspects and embodiments of the present invention discussed above (although this is not essential, and other, conventional, techniques for logging the radio frequency spectrum data could be used, if desired).

The waterfall display will, as is known in the art, display frequency against time, and preferably has frequency along a first axis (e.g. the x-axis) and time along a second axis (e.g. the y-axis), and, preferably, otherwise represents (indicates) signal strength visually, e.g. by means of colour. The waterfall display may, e.g., and as is known in the art, be in a two-dimensional form with frequency along a first axis (e.g. the x-axis), and time along a second axis (e.g. the y-axis), and represent a signal strength visually, e.g. by means of colour, or be in a three-dimensional form with frequency along a first axis (e.g. the x-axis), time along a second axis (e.g. the y-axis), and signal strength (amplitude) along a third axis (e.g. the z-axis) (and preferably also additionally represented visually, e.g. by means of colour).

Similarly, the step of or means for selecting a reference waveform for use with the set of logged radio frequency spectrum data displayed on the waterfall display; in one preferred embodiment comprises selecting, or means (e.g. a user interface) for selecting, a subset of the radio frequency spectrum data on the waterfall display to be used as a reference waveform.

In this case, it is preferably possible either to select spectrum data for a single point in time for use as the reference waveform, or to select spectrum data for a time range (a time period) that can then be used (e.g. in a consolidated form) as a reference waveform.

In another preferred embodiment, the step of or means for selecting a reference waveform for use with the set of logged radio frequency spectrum data displayed on the waterfall display comprises selecting a (previously) stored spectrum waveform for use as a reference waveform.

In a preferred embodiment, it is possible to select a plurality of reference waveforms.

The mathematical function that is performed using the selected reference waveform can be selected as desired. In one preferred embodiment it comprises subtracting the reference waveform from the first waterfall display (from the set of logged radio frequency spectrum data that is being displayed) to provide a result set of radio frequency spectrum data that can be, and is preferably, displayed as a second, result waterfall display.

In another preferred embodiment, the mathematical function comprises combining a plurality of selected reference waveforms, for example, and preferably, using either a maximum or minimum function to show a maximum or minimum signal strength of the selected reference waveforms at a or each recorded frequency.

In some embodiments, the apparatus comprises, and/or is in communication with, one or more memories and/or memory devices that store the spectrum data described herein, and/or store software for performing the processes described herein. The apparatus may also be in communication with a host microprocessor, and/or with a display for displaying plots based on the data generated by the apparatus.

The present invention can be implemented in any suitable system, such as a suitably configured micro-processor based system. In a preferred embodiment, the present invention is implemented in a computer and/or micro-processor based system.

The various functions of the present invention can be carried out in any desired and suitable manner. For example, the functions of the present invention can be implemented in hardware or software, as desired. Thus, for example, the various functional elements and "means" of the invention may comprise a suitable processor or processors, controller or controllers, functional units, circuitry, processing logic, microprocessor arrangements, etc., that are operable to perform the various functions, etc., such as appropriately configured dedicated hardware elements or processing circuitry, and/or programmable hardware elements or processing circuitry that can be programmed to operate in the desired manner.

It should also be noted here that, as will be appreciated by those skilled in the art, the various functions, etc., of the present invention may be duplicated and/or carried out in parallel on a given processor. Equally, the various processing stages may share processing circuitry, if desired.

The present invention is applicable to any form or configuration of spectrum analyser and to all forms of spectrum analysis.

Thus the present invention extends to a spectrum analyser including or forming part of the apparatus of or operated in accordance with any one or more of the aspects and embodiments of the invention described herein. Subject to any hardware necessary to carry out the specific functions discussed above, such a spectrum analyser can otherwise include any one or more or all of the usual functional units, etc., that spectrum analysers include.

It will also be appreciated by those skilled in the art that all of the described aspects and embodiments of the present invention can, and preferably do, include, as appropriate, any one or more or all of the preferred and optional features described herein.

The methods in accordance with the present invention may be implemented at least partially using software e.g. computer programs. It will thus be seen that when viewed from further aspects the present invention provides computer software specifically adapted to carry out the methods herein described when installed on data processing means, a computer program element comprising computer software code portions for performing the methods herein described when the program element is run on data processing means, and a computer program comprising code means adapted to perform all the steps of a method or of the methods herein described when the program is run on a data processing system. The data processor may be a microprocessor system, a programmable FPGA (field programmable gate array), etc..

The invention also extends to a computer software carrier comprising such software which when used to operate a spectrum analyser comprising data processing means which causes, in conjunction with said data processing means, said processor to carry out the steps of the methods of the present invention. Such a computer software carrier could be a physical storage medium such as a ROM chip, RAM, flash memory, CD ROM or disk, or could be a signal such as an electronic signal over wires, an optical signal or a radio signal such as to a satellite or the like.

It will further be appreciated that not all steps of the methods of the invention need be carried out by computer software and thus from a further broad aspect the present invention provides computer software and such software installed on a computer software carrier for carrying out at least one of the steps of the methods set out herein.

The present invention may accordingly suitably be embodied as a computer program product for use with a computer system. Such an implementation may comprise a series of computer readable instructions fixed on a tangible medium, such as a non-transitory computer readable medium, for example, diskette, CD-ROM, ROM, RAM, flash memory or hard disk. It could also comprise a series of computer readable instructions transmittable to a computer system, via a modem or other interface device, over either a tangible medium, including but not limited to optical or analogue communications lines, or intangibly using wireless techniques, including but not limited to microwave, infrared or other transmission techniques. The series of computer readable instructions embodies all or part of the functionality previously described herein.

Those skilled in the art will appreciate that such computer readable instructions can be written in a number of programming languages for use with many computer architectures or operating systems. Further, such instructions may be stored using any memory technology, present or future, including but not limited to, semiconductor, magnetic, or optical, or transmitted using any communications technology, present or future, including but not limited to optical, infrared, or microwave. It is contemplated that such a computer program product may be distributed as a removable medium with accompanying printed or electronic documentation, for example, shrink-wrapped software, pre-loaded with a computer system, for example, on a system ROM or fixed disk, or distributed from a server or electronic bulletin board over a network, for example, the Internet or World Wide Web.

A number of preferred embodiments of the present invention will now be described by way of example only and with reference to the accompanying drawings, in which:
Figure 1 shows an apparatus for logging radio frequency spectrum data according to an embodiment of the present invention;
Figure 2 is a plot of the frequency spectrum data for plural time periods according to an embodiment of the present invention;
Figure 3 is a plot of the frequency spectrum data for a given time period (a frequency signature) according to an embodiment of the present invention;
Figure 4 shows a method of logging radio frequency spectrum data according to an embodiment of the present invention;
Figure 5 shows a compare function for comparing radio spectrum data; and
Figure 6 shows a compare function applied to a "waterfall display" according to an embodiment of the present invention.

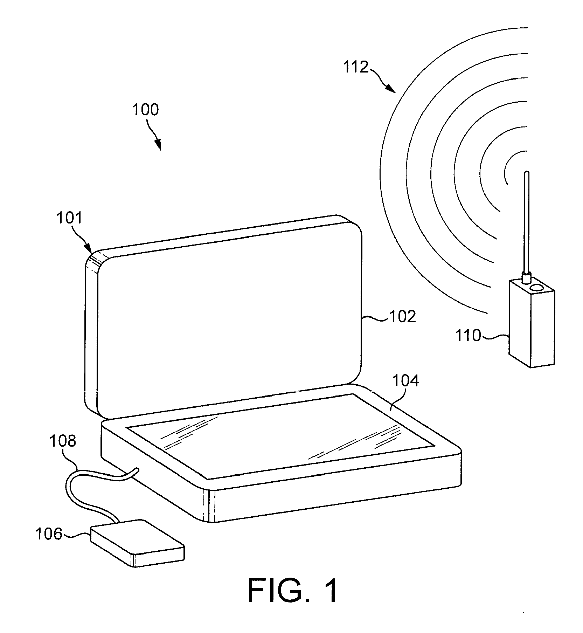

Figure 1 shows an apparatus 100 for logging radio frequency spectrum data according to an embodiment of the present invention. The apparatus 100 comprises a spectrum analyser 101 having an antenna 102 and a housing 104.

The antenna 102 of the spectrum analyser 101 can intercept radio frequency signals 112 from a radio transmitter 110. The radio transmitter 110 may be a covert device or "bug" which is used to record sound and/or video and which periodically transmits the recorded sound and/or video to another covert device (not shown) via the radio frequency signals 112.

The housing 104 of the spectrum analyser 101 contains processing circuitry for logging radio frequency spectrum data. The processing circuitry within the housing 104 samples the radio frequency signals 112 intercepted by the antenna 102 to produce radio frequency spectrum data.

The apparatus 100 also comprises a memory storage device 106 for storing the radio frequency spectrum data. In this embodiment, the memory storage device 106 comprises a USB hard drive which is coupled to the processing circuitry within the housing 104 by a USB cable 106. However, in other embodiments, the memory storage device 106 may form part of the processing circuitry within the housing 104.

The processing circuitry within the housing 104 can produce a plot of the radio frequency spectrum data.

Figure 2 shows a plot 200 of the frequency spectrum data 206 for plural time periods which can be produced using the apparatus 100. The plot 200 displays time along the y-axis 202 and frequency along the x-axis 204. The power of the radio signal received at a given time and frequency is indicated by colour, for example a relatively darker colour is used to show a relatively higher power. The user of the apparatus can choose to display relatively higher or lower resolution (in time) spectrum data. The manner in which the relatively higher or lower resolution (in time) spectrum data is logged is described in more detail below.

Figure 3 shows a plot 300 of the frequency spectrum data 306 for a given time period (frequency signature) which can be produced using the apparatus 100. The plot 300 displays power in decibels along the y-axis 302 and frequency along the x-axis 304. The plot 300 of Figure 3 may be produced upon selection by a user of the apparatus 100 of a given time on the y-axis 202 of the plot 200 of Figure 2.

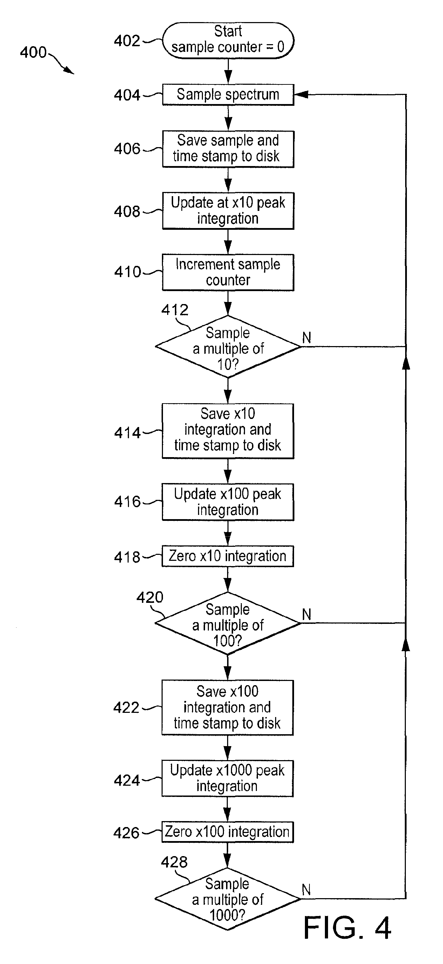

The manner in which radio frequency spectrum data is logged in the present embodiment will now be described with reference to Figure 4, which shows a method 400 of logging radio frequency spectrum data according to an embodiment of the present invention.

The method 400 begins at step 402 in which a sample counter of the processing circuitry is set to zero. At step 404, the signals received by the antenna 102 are sampled over a spectrum of radio frequencies for a one second time period to produce spectrum data. At step 406, the spectrum data and a corresponding time stamp are saved to the memory storage device 106. This spectrum data is relatively higher resolution (in time) spectrum data. At step 408, consolidated (x10) spectrum data for the current 10 time period subset (i.e. a 10 second period) is produced by retaining in memory the peak signal power at each sampled frequency. This comprises comparing the signal power at each sampled frequency with the peak signal power previously stored as the consolidated (x10) spectrum data for that sampled frequency for the 10 time period subset in question. This consolidated (x10) spectrum data is relatively lower resolution (in time) spectrum data. At step 410, the sample counter is incremented by 1. At step 412, it is determined whether or not the sample counter value is a multiple of 10. If the sample counter value is not a multiple of 10, then the process returns to step 404.

If the sample counter value is a multiple of 10, then the process continues to step 414. At step 414, the consolidated (x10) spectrum data for the previous 10 time period subset (the previous 10 second period) and a corresponding time stamp are saved to the memory storage device 106. At step 416, further consolidated (x100) spectrum data for the current 100 time period subset (i.e. a 100 second period) is produced by retaining in memory the peak signal power at each sampled frequency. This comprises comparing the signal power at each sampled frequency with the peak signal power previously stored as the further consolidated (x100) spectrum data for that sampled frequency for the 100 time period subset in question. This further consolidated (x100) spectrum data is relatively even lower resolution (in time) spectrum data. At step 418, the consolidated (x10) spectrum data is cleared. At step 420, it is determined whether or not the sample counter value is a multiple of 100. If the sample counter value is not a multiple of 100, then the process returns to step 404.

If the sample counter value is a multiple of 100, then the process continues to step 422. At step 422, the further consolidated (x100) spectrum data and a corresponding time stamp are saved to the memory storage device 106. At step 424, further consolidated (x1000) spectrum data for the current 1000 time period subset (i.e. a 1000 second period) is produced by retaining in memory the peak signal power at each sampled frequency. This comprises comparing the signal power at each sampled frequency with the peak signal power previously stored as the consolidated (x1000) spectrum data for that sampled frequency for the 1000 time period subset in question. This further consolidated (x1000) spectrum data is relatively even lower resolution (in time) spectrum data. At step 426, the further consolidated (x100) spectrum data is cleared. At step 428, it is determined whether or not the sample counter value is a multiple of 1000. If the sample counter value is not a multiple of 1000, then the process returns to step 404.

Although only the process for up to 1000 time period subsets is shown in Figure 4, it is contemplated that the process may continue in a similar way for 10,000 time period subsets, 100,000 time period subsets, etc.. Thus, if the sample counter value is a multiple of 1000, then the process may continue with steps similar to steps 420-428 (but for 10,000 time periods rather than 1000 time periods) and so on.

In this embodiment, the time period between iterations of step 404 is 1 second, although shorter or longer time periods can be used.

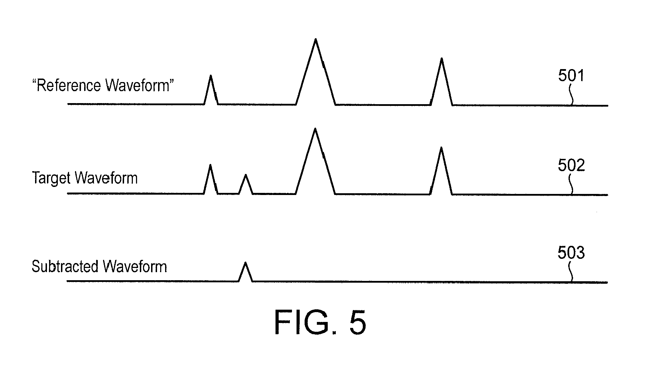

An embodiment for comparing radio frequency spectrum data will now be described with reference to Figure 5, which shows the subtraction of a reference waveform 501 from a target waveform 502 to provide a result waveform 503 for analysis.

The arrangement shown in Figure 5 compares radio spectrum data from one moment in time and/or physical location with radio spectrum data of another moment in time and/or physical location. In this embodiment, the comparison of the radio spectrum data is carried out by (a) recording radio spectrum data in a "safe area" (an area thought not to have any hostile transmissions) as a reference waveform 501, (b) recording radio spectrum data in a (user selectable) target area as a target waveform 502, and (c) subtracting the reference waveform 501 from the target waveform 502 to give a result, "subtracted", waveform 503. In this way, any signals which appear only in the target area can be more easily identified.

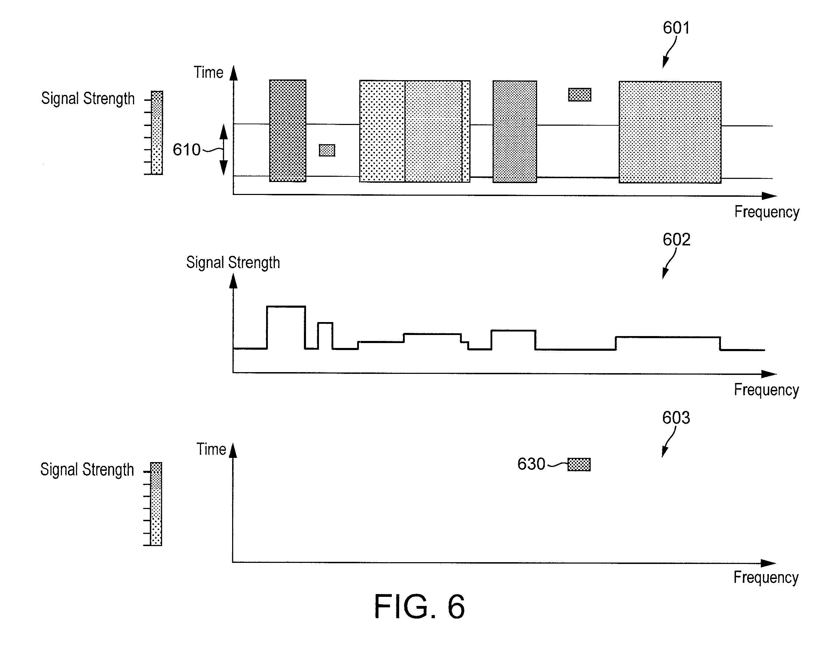

Figure 6 shows another embodiment for comparing radio spectrum data in a "waterfall display" 601. The "waterfall display" 601 displays frequency along a first axis (the x-axis) and time along a second axis (the y-axis) and uses colour to represent signal strength. Alternatively, the "waterfall display" may be a three-dimensional representation (not shown) that displays frequency along a first axis (e.g. the x-axis), time along a second axis (e.g. the y-axis) and signal strength (amplitude) along a third axis (e.g. the z-axis), and, preferably, also uses colour to represent signal strength.

As shown in Figure 6, the user may select a time range 610 to be used as a reference waveform. This is a period of time in which the user believes that there were no hostile transmissions.

A reference waveform 602 for this time period 610 is created by using a 'peak detect' algorithm to find the highest signal strength at each frequency during the time range selected by the user.

The "waterfall display" is then updated by subtracting the reference waveform 602 from the radio spectrum data of the "raw" "waterfall display" 601, to display a resulting "waterfall display" 603. Any signal(s) 630 remaining after subtraction of the reference waveform 602 are displayed in the result "waterfall display". The user can then easily identify the signals of interest, as the result "waterfall display" 603 is less cluttered than the "raw" "waterfall display" 601.

Although not shown in Figure 6, the user may optionally select a plurality of reference waveforms (e.g, two or more), and combine them with a maximum function to show the maximum signal strength in the reference waveforms recorded at any desired frequency. The user can then apply the combined reference waveforms to the "raw" "waterfall display" as described above. Alternatively, the user may optionally select a plurality of reference waveforms (e.g. two or more) and combine them with a minimum function to show a minimum signal strength in the reference waveforms recorded at any frequency. The user can then apply the reference waveforms to the "raw" "waterfall display" as described above.

It can be seen from the above that the present invention, in its preferred embodiments at least, provides a way to log and/or compare spectrum data which can reduce the burden of analyzing large amounts of spectrum data whilst also allowing the finer detail of the spectrum data to be analysed.

This is achieved, in the preferred embodiments of the present invention at least, by storing both spectrum data for each time period of a set of plural time periods (e.g. for each 1 second time period of a set of many 1 second time periods) and consolidated spectrum data for subsets of the time periods (e.g. for subsets comprising 10, 100, 1000, etc. successive 1 second time periods) in memory.

Further, the user can apply a mathematical function to display a result "waterfall display" from a "raw" "waterfall display" that is less cluttered and easier to analyse.

## Claims

1. A method of logging radio frequency spectrum data comprising:
sampling radio signals over a spectrum of radio frequencies for each time period of a set of plural time periods to give respective spectrum data for each of the time periods of the set of plural time periods;
storing the respective spectrum data for each of the time periods of the set of plural time periods in memory;
consolidating the spectrum data for subsets of time periods of the set of plural time periods to give respective consolidated spectrum data for each of the subsets of time periods of the set of plural time periods; and
storing the consolidated spectrum data for each of the subsets of time periods in the set of plural time periods in memory.

2. The method of claim 1, further comprising:
sampling radio signals for a first time period of a first subset of the set of plural time periods;
storing the spectrum data for the first time period and consolidating the spectrum data for the first subset of the set of plural time periods;
sampling radio signals for a second time period of the first subset of the set of plural time periods;
storing the spectrum data for the second time period and consolidating the spectrum data for the first subset of the set of plural time periods; and
repeating the process of above for the remaining subsets of the set of plural time periods.

3. The method of claim 1 or 2, further comprising:
consolidating consolidated spectrum data for plural smaller subsets of time periods of the set of plural time periods to give consolidated spectrum data for a larger subset of time periods of the set of plural time periods.

4. The method of claim 1, 2 or 3, further comprising:
displaying the radio frequency spectrum data as a waterfall display; and
changing the time resolution of the displayed radio frequency spectrum data in response to a user input, wherein changing the time resolution of the displayed radio frequency spectrum data comprises:
if the user selects a first lower time resolution, plotting and displaying only the consolidated spectrum data for a subset or subsets of time periods of the set of plural time periods; or
if the user selects a second higher time resolution, plotting and displaying only the respective spectrum data for a time period or periods of the set of plural time periods.

5. A method of analysing radio frequency spectrum data, the method comprising:
displaying a set of logged radio frequency spectrum data as a waterfall display;
selecting a reference waveform for use with the set of logged radio frequency spectrum data displayed on the waterfall display;
performing a mathematical function using the selected reference waveform; and
displaying the result of the mathematical function.

6. The method of claim 5, comprising:
selecting a subset of the radio frequency spectrum data on the waterfall display to be used as a reference waveform; or
selecting a stored waveform to be used as a reference waveform.

7. The method of claim 5 or 6, wherein the logged radio frequency spectrum data is logged in a manner according to any one of claims 1 to 4.

8. An apparatus for logging radio frequency spectrum data comprising:
means for sampling radio signals over a spectrum of radio frequencies for each time period of a set of plural time periods to give respective spectrum data for each of the time periods of the set of plural time periods;
means for storing the respective spectrum data for each of the time periods of the set of plural time periods in memory;
means for consolidating the spectrum data for subsets of time periods of the set of plural time periods to give respective consolidated spectrum data for each of the subsets of time periods of the set of plural time periods; and
means for storing the consolidated spectrum data for each of the subsets of time periods in the set of plural time periods in memory.

9. The apparatus of claim 8, further comprising:
means for sampling radio signals for a first time period of a first subset of the set of plural time periods;
means for storing the spectrum data for the first time period and consolidating the spectrum data for the first subset of the set of plural time periods;
means for sampling radio signals for a second time period of the first subset of the set of plural time periods;
means for storing the spectrum data for the second time period and consolidating the spectrum data for the first subset of the set of plural time periods; and
means for repeating the process above for the remaining subsets of the set of plural time periods.

10. The apparatus of claim 8 or 9, further comprising:
means for consolidating consolidated spectrum data for plural smaller subsets of time periods of the set of plural time periods to give consolidated spectrum data for a larger subset of time periods of the set of plural time periods.

11. The apparatus of claim 8, 9 or 10, further comprising:
means for displaying the radio frequency spectrum data as a waterfall display; and
means for changing the time resolution of the displayed radio frequency spectrum data in response to a user input, wherein changing the time resolution of the displayed radio frequency spectrum data comprises:
if the user selects a first lower time resolution, plotting and displaying only the consolidated spectrum data for a subset or subsets of time periods of the set of plural time periods; or
if the user selects a second higher time resolution, plotting and displaying only the respective spectrum data for a time period or periods of the set of plural time periods.

12. An apparatus for analysing radio frequency spectrum data, the apparatus comprising:
means for displaying a set of logged radio frequency spectrum data as a waterfall display;
means for selecting a reference waveform for use with the set of logged radio frequency spectrum data displayed on the waterfall display;
means for performing a mathematical function using the selected reference waveform; and
means for displaying the result of the mathematical function.

13. The apparatus of claim 12, wherein the means for selecting a reference waveform for use with the set of logged radio frequency spectrum data displayed on the waterfall display comprises:
means for selecting a subset of the radio frequency spectrum data on the waterfall display to be used as a reference waveform; or
means for selecting a stored waveform to be used as a reference waveform.

14. The apparatus of claim 12 or 13, wherein the set of logged radio frequency spectrum data is logged using the apparatus of any one of claims 8 to 11.

15. A computer program element comprising computer software code portions for performing the method of any one of claims 1 to 7 when the program is run on data processing means.
